# EUROPEAN PATENT APPLICATION

(11) **EP 1 889 947 A1**
(43) Date of publication of application: **20.02.2008**
(21) Application number: 06731455.9
(22) Date of filing: 03.04.2006
(51) Int. Cl.: C23C 16/511

(54) **METHOD AND DEVICE FOR FORMING VAPOR DEPOSITION FILM BY SURFACE LIQUID PLASMA**

(30) Priority: 06.04.2005 JP 2005109337; 19.04.2005 JP 2005121206
(71) Applicant: TOYO SEIKAN KAISHA, LTD., Tokyo 100-8522 (JP)
(72) Inventor: YAMADA, Kouji, Toyo Seikan Group Corp. Rsch. Dev., Yokohama-shi, Kanagawa 2400062 (JP); KUNIHIRO, I., Toyo Seikan Group Corp. Rsch. Dev., Yokohama-shi, Kanagawa 2400062 (JP); INAGAKI, Hajime, Toyo Seikan Group Corp. Rsch. Dev, Yokohama-shi, Kanagawa 2400062 (JP); KURASHIMA, Hideo Toyo Seikan Group Corp. Rsch. Dev, yokohama-shi, Kanagawa 2400062 (JP)
(74) Representative: Manley, Nicholas Michael
(86) International application number: PCT/JP2006/307508
(87) International publication number: WO 2006/109754

(57) **Abstract**

A vapor deposition film formation method includes a step for arranging a surface wave generating device (10) using a microwave in a vacuum region, a step for continuously feeding a plastic film substrate (13) into the vacuum region so as to oppose to the surface wave generating device, a step of continuously supplying a reaction gas containing at least organic metal compound into the vacuum region, and a step for executing plasma reaction by the surface wave of the microwave from the surface wave generating device (10), thereby continuously forming a vapor deposition film on the surface of the film substrate (13). This method enables continuous formation of a vapor deposition film on the surface of a film substrate, especially a long film, by the surface wave plasma of the microwave.

## Description

### Technical Field

The present invention relates to a method of forming a vapor deposited layer by surface-wave plasma and to an apparatus for executing the method. More specifically, the invention relates to a method of forming a vapor deposited layer by a plasma CVD method by utilizing surface-wave plasma by microwave and to an apparatus therefor.

### Background Art

In order to improve properties of various base materials, it has been attempted to form a vapor deposited layer on their surfaces by a plasma CVD method. In the field of packaging materials, it is a known practice to improve gas barrier property by forming a vapor deposited layer on the plastic base materials such as containers and films by the plasma CVD method. For example, there has been known a method of forming a vapor deposited layer comprising a silicon oxide or a compound containing carbon, silicon and oxygen as constituent elements on the surfaces of the plastic base material by the plasma CVD method by using an organometal compound such as an organosilicon compound and an oxygen gas.

Here, the plasma CVD is a process for growing a thin film layer by utilizing a plasma, and according to which a gas containing starting compound is decomposed by an electric discharge of electric energy in a high electric field under a reduced pressure, and the formed reaction species (plasma) is deposited on a base material through a chemical reaction performed in a gaseous phase or on the base material. A method has been known for realizing the above plasma state by utilizing a microwave glow discharge.

Concerning the method of forming the vapor deposited layer by the plasma CVD by using microwave, various surface-wave plasmas have recently been proposed by utilizing surface-wave of microwave (patent documents 1 and 2).
Patent document 1: JP-A-10-158847
Patent document 2: JP-A-2001-118698

The surface-wave plasma by microwave generates a homogeneous and high-density plasma having large areas, and has been utilized for vapor deposition on the base material surfaces such as liquid crystal base materials and semiconductor wafers.

However, the known methods and apparatuses for forming the vapor deposited layer by surface-wave plasma are all conducted in a so-called batchwise system, and are not suited for the continuous production. Namely, they are not suited for forming the vapor deposited layer on the surfaces of a film and, particularly, a long film wound on a roller. Further, when the vapor deposited layer is to be formed by using the organometal compound such as the above-mentioned organosilicon compound as a reaction gas component, it has been known that the vapor deposited layer can be formed having a layer structure in which the composition varies continuously upon varying the composition of the reaction gas and the conditions for forming the plasma. By utilizing this method, it can be contrived to form, for example, a organic layer rich in organic components and having favorable adhesive property on the surface of the base material, and to form a barrier layer rich in metal oxide components and having favorable gas-barrier property on the organic layer. However, the conventional methods and apparatuses based on surface-wave plasma are not suited for forming the vapor deposited layer having the above layer structure.

According to the methods of forming the vapor deposited layer by surface-wave plasma disclosed in the patent documents 1 and 2, the base material is so arranged as to face the surface-wave feeding device for microwave and a reactive gas is fed to between the above two enabling the vapor deposited layer to be formed on the surface of the base material on the side facing the surface-wave feeding device. A method has further been proposed for forming the vapor deposited layer on the surface of the base material on the side opposite to the side facing the surface-wave feeding device (patent document 3).
Patent document 3: JP-A-62-294181

According to the method of the patent document 3, a base material that permits microwave to pass through is arranged near or in close contact with a dielectric electrode plate provided in the the surface-wave feeding device, and a reaction gas is fed onto the surface of the base material on the side opposite to the surface-wave feeding device to thereby form a vapor deposited layer by the surface-wave plasma. With this method, the vapor deposited layer is formed on the surface of the base material on the side opposite to the surface-wave feeding device offering an advantage of effectively avoiding the deposition of the reaction product on the surface-wave feeding device.

However, the method disclosed in the patent document 3 still has a problem that must be solved with respect to continuously forming the vapor deposited layer on a long plastic film. That is, according to this method, microwave must pass through the base material and, therefore, the base material that permits microwave to pass through must be brought into close contact with the surface-wave feeding device or the gap between the two must be set to lie in a very small range. Therefore, a problem arouses if it is attempted to form the vapor deposited layer on a long plastic film which is a base material that permits microwave to pass through while continuously moving the long plastic film. For example, if the long film is moved in close contact with the surface-wave feeding device, then the long film is abraded. If the long film is moved maintaining a very small gap relative to the surface-wave feeding device, on the other hand, a uniform gap is not maintained between the two as the film undergoes the swinging, and the thickness of the vapor deposited layer disperses.

### Disclosure of the Invention

It is therefore an object of the present invention to provide a method of forming a vapor deposited layer, which is capable of continuously forming a vapor deposited layer on the surface of the base film and, particularly, on the surface of a long film by surface-wave plasma of microwave, and an apparatus for putting the method into practice.

Another object of the present invention is to provide a method of forming a vapor deposited layer, which is capable of forming a vapor deposited layer having a multi-layer structure on the surface of the base film and, particularly, on the surface of a long film, and an apparatus for putting the method into practice.

A further object of the present invention is to provide a microwave feeding device which is used for forming a vapor deposited layer by the plasma CVD due to surface-wave of microwave, effectively suppresses inconvenience such as abrasion, and is capable of forming the vapor deposited layer maintaining a uniform thickness on the surface of a long film, and an apparatus for forming a vapor deposited layer equipped with the above surface-wave feeding device.

According to the present invention, there is provided a method of forming a vapor deposited layer comprising following steps of:
arranging a surface-wave generator for generating surface-wave by microwave in a vacuum region;
continuously feeding a plastic base film into said vacuum region so as to face said surface-wave generator;
continuously feeding a reaction gas containing at least an organometal compound into said vacuum region; and
executing a plasma reaction by surface-wave of microwave from said surface-wave generator to thereby continuously form a vapor deposited layer on a surface of the base film.

It is desired that the method of forming a vapor deposited layer of the invention employs the following means:
(1) A plurality of the surface-wave generators are arranged side by side along a direction in which said base film moves, gaps among the adjacent surface-wave generators are partitioned to a degree that permits said base film to move, and the vapor deposited layer is continuously formed on the surface of said base film by the plasma reaction due to the surface-wave generators while continuously moving said base film.
(2) By varying, for each of the surface-wave generators, the kind or composition of the reaction gas or the output of microwave, the plasma reaction is executed in every surface-wave generators to form the vapor deposited layer having a multi-layer constitution on the base film.
(3) A long film is used as said base film.
(4) A starting material roller on which said long film is wound and a take-up roller for taking up said long film are arranged in said vacuum region, and the vapor deposited layer is continuously formed on the surface of said long film while the long film wound on said starting material roller is being taken up by the take-up roller.
   In the method of forming the vapor deposited layer of the present invention, the vapor deposited layer can be formed on the surface of the base film on the side facing the surface-wave generator or on the surface thereof on the side opposite to the surface of the side that faces the surface-wave generator.
   When the vapor deposited layer is formed on the surface of the base film on the side facing the surface-wave generator (hereinafter called "facing-deposition") according to the method of the present invention, it is desired that:
(5) Said base film is fed maintaining a gap to said surface-wave generator, and said reaction gas is fed so as to flow into spaces between said base film and the surface-wave generator, to thereby form the vapor deposited layer on the surface of said base film on the side facing the surface-wave generator.
   When the vapor deposited layer is formed on the surface of the base film on the side opposite to the side that faces the devices for generating surface-waves (hereinafter called "opposite-deposition") according to the method of the present invention, it is desired that:
(6) A surface for emitting surface-wave of said surface-wave generator is formed as a curved surface, and said base film is fed along said curved surface in a manner that the one surface thereof comes in close contact with said curved surface, to thereby form the vapor deposited layer on the other surface of said base film.
   According to the present invention, there is provided an apparatus for forming a vapor deposited layer (hereinafter called "facing-deposit apparatus") comprising a base material conveyer chamber and a vapor deposition chamber formed so as to be communicated with each other in a housing maintained in a vacuum state, wherein:
   a starting material roller and a take-up roller are arranged in said base material conveyer chamber;
   a support roller is arranged in said vapor deposition chamber, and a plurality of plasma regions sectioned by partitioning members are formed surrounding said support roller along a surface of said support roller;
   in each of said plasma regions, there are provided a surface-wave generator for generating surface-wave by microwave supported by a housing wall that is forming said vapor deposition chamber, and a gas feed pipe inserted in a space between said surface-wave generator and the surface of the support roller; and
   by executing a plasma reaction in each of the plasma regions due to feeding surface-wave of microwave from the surface-wave generator and feeding a reaction gas from the gas feed pipe while taking up, on said take-up roller, a long film wound on said starting material roller, a vapor deposited layer is continuously formed on a surface of the long film on the side facing the surface-wave generator.

   In the above facing-deposit apparatus, it is desired that:
(7) Said partitioning members are deaerating members.
(8) A housing wall forming said vapor deposition chamber is formed in a circular shape in concentric with the surface of said support roller.
(9) A film surface-treating device is arranged in said base material conveyer chamber, and after a surface of the long film is treated by said film surface-treating device, the long film is fed onto the support roller so that the vapor deposited layer is formed thereon.
   According to the present invention, there is further provided a microwave feeding device for plasma CVD comprising a hollow support member of which an outer surface is at least curved, and a surface-wave generator for generating surface-wave by microwave supported by said hollow support member, wherein:
   said surface-wave generator is constituted by a waveguide connecting to a microwave feed source and extending in said hollow support member, a slot antenna incorporated in a shielding wall of said waveguide and a dielectric electrode plate which is so provided as to cover said slot antenna, said dielectric electrode plate being incorporated and fixed in the wall of said hollow support member in a manner that the outer surface thereof is exposed; and
   an outer surface of said dielectric electrode plate is curved so as to be smoothly continuous to the outer surface of said hollow support member.

   The above microwave feeding device can be effectively applied particularly for the opposite-deposition. In the microwave feeding device, it is desired that:
(10) Said hollow support member has the shape of a roller, and the outer surface of said dielectric electrode plate is formed in a circular shape substantially in concentric with the outer surface of said roller-shaped hollow support member.
(11) A plurality of the surface-wave generators are supported on the curved surface of said hollow support member along the circumferential direction thereof.
   According to the present invention, there is further provided an apparatus for forming a vapor deposited layer (hereinafter called "opposite-deposit apparatus" comprising a starting material roller on which a long plastic film is wound, a take-up roller for taking up said film, and the above-mentioned a microwave feeding device for plasma CVD in a housing maintained in a vacuum state, wherein:
   a gas feed pipe is extending facing an outer surface of the dielectric electrode plate of the microwave feeding device maintaining a small gap; and
   by executing a plasma reaction due to feeding surface-wave of microwave and feeding a reaction gas from the gas feed pipe while taking up, on said take-up roller, the long plastic film wound on said starting material roller along the curved surface of the hollow support member of the microwave feeding device and passing through between the hollow support member and the gas feed pipe, a vapor deposited layer is continuously formed on the surface of the long plastic film on the side that does not face an outer surface of the dielectric electrode plate.

   In the above opposite-deposit apparatus, too, it is desired that:
(12) A film surface-treating device is arranged in said housing, and after the surface of the long plastic film is treated by said film surface-treating device, said long plastic film is fed passing through between said hollow support member and the gas feed pipe so that the vapor deposited layer is formed thereon.

According to the method of the present invention, the vapor deposited layer is formed by surface-wave plasma while moving the base film so as to face the surface-wave generator by microwave arranged in the vacuum region. Therefore, the vapor deposited layer can be continuously formed maintaining a very high productivity. In particular, the starting material roller and the take-up roller are arranged in the vacuum region, and the long film is taken up by the take-up roller from the starting material roller. In this case, employment of the method of the present invention makes it possible to continuously form a vapor deposited layer of a large area on the long film, too.

In the facing-deposit apparatus for favorably putting the above method into practice, the plasma regions where the surface-wave generators and the reaction gas feed pipes are provided, are formed side by side along the direction in which the long film moves being stretched by the support roller. Upon employing different reaction conditions (such as kind and composition of the reaction gases, microwave output of the surface-wave generator) in the plasma regions, therefore, it is made possible to continuously form the vapor deposited layer having a multi-layer structure on the long film.

In the microwave-feeding device of the invention applied to the opposite-deposition, further, the surface-wave generator by microwaves is supported by the hollow support member and, particularly, the dielectric electrode plate that emits surface-wave of microwave has a curved surface smoothly continuous to the curved surface of the support member. Therefore, the vapor deposited layer can be formed on the opposite surface of the film (surface on the side which is not facing the surface-wave generator) by the plasma reaction due to feeding microwaves in the form of surface-wave onto the opposite surface while continuously moving the long plastic film along the outer surface of the hollow support member. Namely, since the outer surface of the dielectric electrode plate has been curved as described above, the film is effectively suppressed from being abraded by the contact with the outer surface of the dielectric electrode plate. Besides, the film moves in close contact with the outer surface of the dielectric electrode plate. Therefore, no dispersion occurs in the gap between the two, and the vapor deposited layer having a uniform thickness can be continuously formed.

Moreover, in the opposite-deposit apparatus of the invention equipped with the microwave-feeding device, the microwave-feeding device is provided between the starting material roller and the take-up roller, and the long plastic film is taken up by the take-up roller from the starting material roller passing on the curved surface of the hollow support member in the microwave-feeding device. Therefore, the vapor deposited layer can be continuously formed on the surface of the long plastic film (on the surface of the side that is not facing the curved surface of the hollow support member) while the long film is being taken up by the take-up roller from the starting roller.

In the opposite-deposit apparatus, further, a plurality of surface-wave generators are held on the curved surface of the hollow support member enabling a thick vapor deposited layer to be formed in a short period of time and increasing the rate of production. By varying the microwave output of the surface-wave generators, further, the vapor deposited layer can be formed having a structure in which layers having different element compositions are laminated one upon the other.

### Brief Description of the Drawings

Fig. 1 is a view illustrating a principle of a method of forming a vapor deposited layer by the facing-deposition relying on a plasma reaction by utilizing surface-wave of microwave;
Fig. 2 is a view illustrating a principle of a method of forming a vapor deposited layer by the opposite-deposition relying on the plasma reaction by utilizing surface-wave of microwave;
Fig. 3 is a view illustrating the structure of an apparatus for forming a vapor deposited layer (facing-deposit apparatus) according to the present invention; and
Fig. 4 is a diagram illustrating the structure of an apparatus for forming a vapor deposited layer (opposite-deposit apparatus) equipped with a microwave-feeding device to the present invention.

### <Best Mode for Carrying Out the Invention>

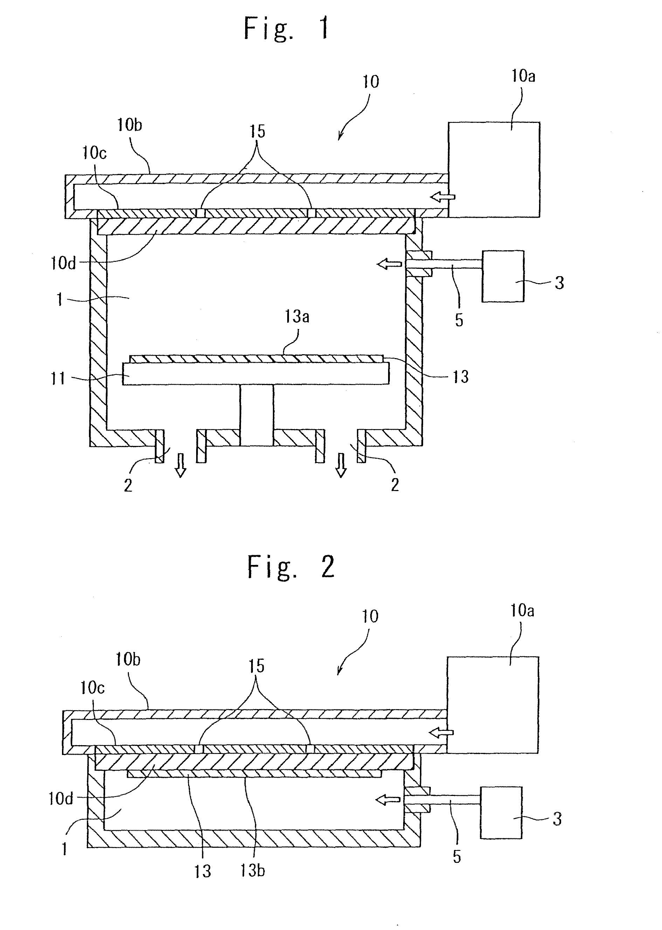

According to the present invention, a vapor deposited layer can be formed on the surface of a base film by a plasma reaction by using surface-wave of microwave. This method can be roughly divided the facing-deposition for forming the vapor deposited layer on the surface of a plastic base film on the side facing the surface-wave feeding device and the opposite-deposition for forming the vapor deposited layer on the surface of the plastic base film on the side opposite to the side that faces the surface-wave feeding device. The principles of these methods will be described with reference to Figs. 1 and 2.

Referring, first, to Fig. 1 illustrating the principle of the facing-deposition, deaerating ports 2 and 2 are formed in a chamber 1, and the interior of the chamber 1 is maintained at a predetermined degree of vacuum. A gas feed pipe 5 leading to a gas feed source 3 is connected to a side wall of the chamber 1, and a predetermined reaction gas is fed into the chamber 1. A surface-wave generator generally designated at 10 is mounted on the upper wall of the chamber 1, a support stage 11 is arranged so as to face the surface-wave generator 10, and a base film 13 on which a vapor deposited layer is to be formed is placed on the support stage 11.

The surface-wave generator 10 has a waveguide 10b connected to a microwave feed source 10a, a slot antenna 10c is formed on the shielding wall which is the side surface of the waveguide 10b, and a dielectric electrode plate 10d is so provided as to cover the slot antenna 10c. That is, as will be understood from Fig. 1, the base film 13 is arranged on the support stage 11 so as to face the slot antenna 10c and the dielectric electrode plate 10d.

The slot antenna 10c is made of a metal such as aluminum and in which a plurality of slots 15 are arranged maintaining a distance corresponding to a half wavelength (1/2 λ) of the transmitted microwaves. The dielectric electrode plate 10 is made of a dielectric material having a small dielectric loss and excellent heat resistance, such as quartz glass, alumina or silicon nitride, and has a thickness of, usually, about 10 to about 50 mm.

By using the above surface-wave generator 10, the vapor deposited layer is formed as described below.

That is, the pressure in the chamber 1 is reduced to a vacuum degree (e.g., 1 to 500 Pa, preferably, about 5 to about 50 Pa) at which a glow discharge takes place upon introducing the microwaves. In this state, microwaves are fed from the surface-wave generator 10, the reaction gas containing an organometal compound is fed into the chamber 1 from the gas feed pipe 5, and a vapor deposited layer is formed on the surface of the base film 13.

That is, the microwaves transmitted to the waveguide 10b from the microwave feed source 10a leak in the dielectric electrode plate 10d through the slots 15 in the slot antenna 10c, and diffuse along the wall surface of the dielectric electrode plate 10d to form surface-wave. The surface-wave is emitted into the chamber 1 from the dielectric electrode plate 10d producing a glow discharge, whereby an organometal compound and the like in the reaction gas are decomposed generating reaction species in the plasma state. The reaction products deposit like a film on the surface 13a of the base film 13 on the side facing the surface-wave generator 10 and, thus, the vapor deposited layer is formed.

As described above, the plasma reaction by surface-wave of microwave makes it possible to form a homogeneous plasma of a high density having a large area, and is suited for forming a vapor deposited layer on the surface 13a of the base film 13.

According to the present invention, the vapor deposited layer is formed by the plasma reaction by using surface-wave of microwave while continuously moving the base film 13. Therefore, the vapor deposited layer can be formed on the base film 13 such as a long film maintaining high productivity.

Referring to Fig. 2 illustrating the principle of the opposite-deposition, the chamber is maintained at a predetermined vacuum degree like in Fig. 1 (deaerating ports 2 are omitted in Fig. 2). Further, like in Fig. 1, a gas feed pipe 5 leading to a gas feed source 3 is connected to the chamber 1, and the surface-wave generator 10 is mounted thereon. Unlike that of Fig. 1, however, the base film 13 on which the vapor deposition film is to be formed is positioned in close contact with the surface-wave generator 10.

That is, as will be understood from Fig. 2, the base film 13 which is the long plastic film 13 moves in close contact with the dielectric electrode plate 10d of the surface-wave generator 10. Therefore, the pressure in the chamber 1 is reduced to a predetermined vacuum degree and in this state, microwaves are fed from the surface-wave generator 10, the reaction gas containing an organometal compound is fed into the chamber 1 from the gas feed pipe 5, and a vapor deposited layer is formed on the surface 13b of the base film 13 on the side opposite to the surface that faces the dielectric electrode plate 10d.

In the above opposite-deposition, the microwave transmitted to the waveguide 10b from the microwave feed source 10a leaks in the dielectric electrode plate 10d through the slots 15 in the slot antenna 10c, and diffuse along the wall surface of the dielectric electrode plate 10d to form surface-wave. The surface-wave is emitted into the chamber 1 from the dielectric electrode plate 10d through the base film 13 which permits microwave to pass through producing a glow discharge, whereby an organometal compound and the like in the reaction gas are decomposed generating reaction species in the plasma state. The reaction products deposit like a film on the surface 13b of the base film 13 and, thus, the vapor deposited layer is formed.

The opposite-deposition, too, makes it possible to form a homogeneous plasma of a high density having a large area like the above facing-deposition, and is suited for forming a vapor deposited layer on the surface 13b of the long base film 13. The surface 13b of the base film 13 on which the vapor deposited layer is formed is positioned on the side that is not facing the dielectric electrode plate 10d offering an advantage of effectively avoiding the deposition of the reaction product on the surface-wave generator 10 (dielectric electrode plate 10d). Further, when the vapor deposited layer is formed on the surface 13b of the base film 13, a point of exciting the plasma is located close to the surface 13b of the film 13 offering an advantage of a high film-forming rate.

Described below are the apparatuses for putting the above facing-deposition and the opposite-deposition into practice.

### [Facing-deposit Apparatus]

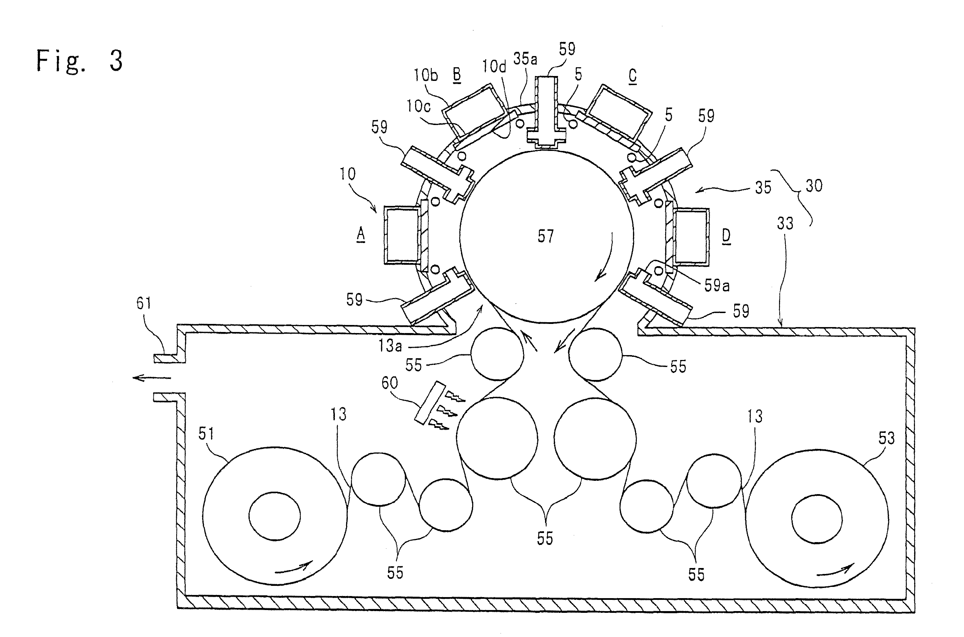

Referring to Fig. 3 illustrating a facing-deposit apparatus for favorably putting the above-mentioned facing-deposition, this apparatus has a housing generally designated at 30. In the housing 30, a base material conveyer chamber 33 and a vapor deposition chamber 35 are formed being communicated with each other.

The base material conveyer chamber 33 contains a starting material roller 51 and a take-up roller 53. A plurality of intermediate rollers 55 are arranged between the rollers 51 and 53. The vapor deposition chamber 35 contains a support roller 57. A deaerating port 61 is formed in the base material conveyer chamber 33, and the interior of the base material conveyer chamber 33 is maintained at a predetermined degree of vacuum.

As will be shown in Fig. 3, a long film (base film) is wound on the starting material roller 51, and is taken up from the starting roller 51 by the take-up roller 53 without slackness via the plurality of intermediate rollers 55, support roller 57 in the vapor deposition chamber 35 and the plurality of intermediate rollers 55. A plurality of plasma regions A to D are formed on the circumferential surface of the support roller 57 along a direction in which the long film 13 moves being conveyed by the roller 57 in the vapor deposition chamber 35 (the number of the plasma regions A to D is not limited to four only, but may be 2 to 3 or 5 or more).

A vapor deposited layer is formed by surface-wave plasma in each of the plasma regions A to D; i.e., the vapor deposited layer is successively formed through the regions A to D as the long film 13 passes over the support roller 57 starting from the starting material roller 51 and is taken up by the take-up roller 55 via the support roller 57.

In the plasma regions A to D, the vapor deposited layer is formed according to the principle described above with reference to Fig. 1. Each of the regions A to D is provided with the surface-wave generator 10, which comprises the above-mentioned waveguide 10b, slot antenna 10c and dielectric electrode plate 10d (microwave feed source 10a of Fig. 1 is not shown). Further, the gas feed pipes 5 coupled to the gas feed source 3 (not shown in Fig. 3) are inserted in the regions A to D.

The gas feed pipe 5 is a metal pipe having many holes perforated therein or is a porous pipe. In the example of Fig. 3, a pair of gas feed pipes 5 and 5 are arranged near the end of the dielectric electrode plate 10d of the surface-wave generator 10. The surface-wave generator 10 is mounted on a housing wall 35a that forms a treating chamber 35.

Further, the regions A to D are sectioned by partitioning walls 59 which are provided to such a degree as will not hinder the conveyance of the long film 13. In the example of Fig. 2, a deaerating member having a deaerating port 59a is used as the partitioning wall 59, and spaces in the regions A to D are so constituted as can be deaerated by the partitioning walls 59 made of the deaerating members.

When the long film 13 on the support roller 57 passes through the plasma regions A to D, the vapor deposited layers are formed on the surface 13a of the long film 13 (surface facing the surface-wave generator 10) through the respective regions A to D. Therefore, the vapor deposited layer finally formed on the surface 13a of the long film 13 has a structure in which the vapor deposited layers are laminated in order of being formed through the plasma regions A, B, C and D.

In the facing-deposit apparatus, the vapor deposited layers are formed through the plasma regions A to D based on the principle described with reference to Fig. 1.

That is, upon the deaeration through the partitioning walls 59 made of the deaerating members, the pressure in the regions A to D are reduced to a predetermined degree of vacuum (here, the pressure is reduced in the whole treating chamber 35). In this state, the reaction gas is fed through the gas feed pipes 5, surface-wave of microwave is fed from the surface-wave generator 10, a state of plasma is generated, and vapor deposited layers due to plasma reactions are formed in the regions A to D.

The reaction gases fed to the regions A to D from the gas feed pipes 5, are discharged through the deaerating ports 59a of the deaerating members forming the partitioning walls 59 and, therefore, the reaction gases of a constant concentration flow into the regions A to D at all times.

In the above-mentioned facing-deposit apparatus as shown in Fig. 3, it is desired that the housing wall 35a forming the vapor deposition chamber 35 has a circularly curved surface in concentric with the circumferential surface of the support roller 57, making it possible to maintain constant the gap between the long film 13 and the dielectric electrode plate 10d of the surface-wave generator 10 provided in each of the plasma regions A to D and, therefore, to bring into agreement the physical conditions for forming the film in the plasma regions A to D. Usually, it is desired that the gap between the dielectric electrode plate 10d and the surface to be treated (i.e., surface 13a) of the long film 13 is set to be about 5 to about 100 mm from the standpoint of homogeneously forming the vapor deposited layer of a high density.

It is further desired that the surface-wave generator 10 is movably mounted on the housing wall 35a by using screws or the like, so that the gap can be freely set between the dielectric electrode plate 10d and the surface 13a to be treated of the long film 13. Here, it is desired that the gas feed pipes 5, too, are allowed to follow the movement. When it is desired to decrease the number of the plasma regions or to conduct maintenance of the dielectric electrode plate 10d, the surface-wave generator 10 can be removed from the housing wall 35a.

It is, further, desired to provide a film surface-treating device 60 in the base material conveyer chamber 33 at a position between the starting material roller 51 and the support roller 57. That is, in a stage before the long film 13 moves onto the support roller 57 to form the vapor deposited layers through the plasma regions A to D, the surface 13a of the long film 13 is treated by the film surface-treating device 60 in order to improve the adhesive property between the vapor deposited layer and the surface of the long film 13.

The film surface-treating device 60, usually, executes a corona treatment or a plasma treatment by using argon, oxygen or the like.

### [Opposite-deposit Apparatus]

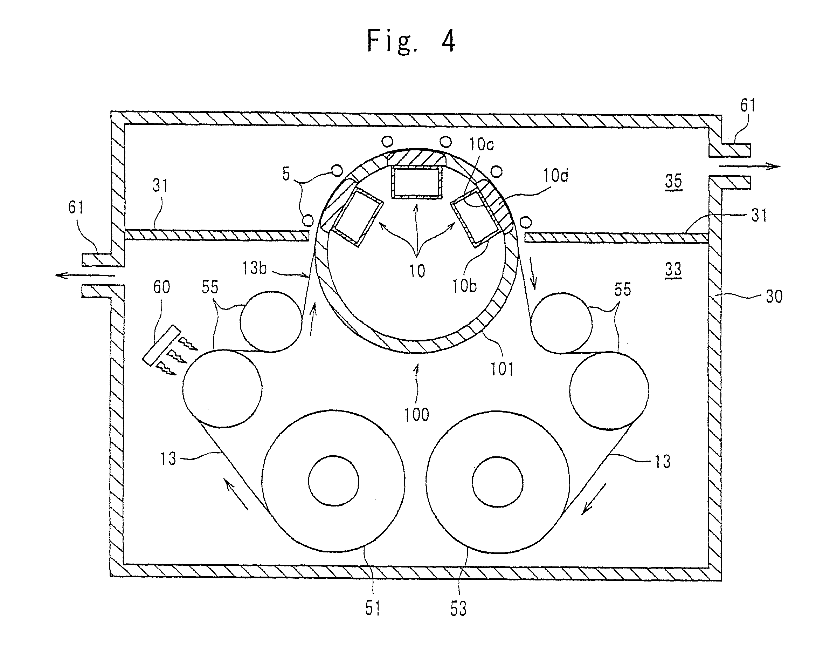

Referring to Fig. 4 illustrating the structure of the opposite-deposit apparatus, a microwave feeding device of the present invention generally designated at 100 is arranged in the housing 30. By using the microwave feeding device 100, a vapor deposited layer is formed on the surface 13b of the long film 13 (surface on the side opposite to the surface that faces the microwave feeding device) according to the above-mentioned principle shown in Fig. 2. In Fig. 4, members common to those of Fig. 3 are denoted by the same reference numerals.

The microwave feeding device 100 has a hollow support roller 101 which does not rotate, and a plurality of (three in Fig. 4) surface-wave devices 10 are supported by the roller 101. The surface-wave devices 10 have waveguides 10b connected to the microwave feed source (not shown in Fig. 4), the waveguides 10b extending in the hollow support roller 101, and the dielectric electrode plates 10d are fixed to the roller wall of the hollow support roller 10 so as to cover the slot antennas 10c (slots 15 are not shown in Fig. 4) attached to the shielding walls of the waveguides 10b.

In the microwave feeding device 100 as will be understood from Fig. 4, the outer surfaces of the dielectric electrode plates 10d fixed to the roller wall of the hollow support roller 101 are forming smoothly continuing curved surfaces and, particularly, are forming circular surfaces in concentric with the roller wall. Therefore, by moving the long film 13 in close contact with the outer surfaces of the dielectric electrode plates 10d, it is allowed to effectively avoid the abrasion of the film 13. From the standpoint of avoiding the abrasion of the film 13, it is desired that the outer surfaces of the dielectric electrode plates 10d are forming mirror surfaces.

There is no particular limitation on the material of the hollow support roller 101. From the standpoint of shielding microwave, however, it is desired to use a metal and at least the circumferential surface of the roller 101 (portion that comes in close contact with the film 13 other than the dielectric electrode plate 10d) is formed like a mirror surface by being plated with chromium.

In the opposite-deposit apparatus of Fig. 4, the interior of the housing 30 is sectioned by partitioning walls 31, 31 into the base material conveyer chamber 33 and the vapor deposition chamber 35 so as to divide into two the hollow support roller 101 possessed by the microwave feeding device 100. Being evacuated by a vacuum pump, the interiors of the base material conveyer chamber 33 and of the plasma-treating chamber 35 (particularly, the interior of the plasma-treating chamber 35) is reduced to a predetermined degree of vacuum. Evacuating ports 61 are formed in the base material conveyer chamber 33 and in the vapor deposition chamber 35. Due to the evacuation by the vacuum pump, the interiors of the base material conveyer chamber 33 and the plasma-treating chamber 35 are reduced to a predetermined degree of vacuum.

The base material conveyer chamber 33 contains the starting material roller 51 and the take-up roller 53 like in the facing-deposit apparatus of Fig. 3, and a plurality of intermediate rollers 55 are arranged between the rollers 51 and 53. That is, the long film 13 is wound on the starting material roller 51, and is taken up from the starting roller 51 by the take-up roller 53 without slackness via the plurality of intermediate rollers 55, microwave feeding device 100 (hollow support roller 101 on which the surface-wave generators 10 are mounted), and the plurality of intermediate rollers 55.

In the vapor deposition chamber 35, further, pairs of gas feed pipes 5, 5 are extending so as to face the dielectric electrode plates 10d of the surface-wave generator 10 mounted on the hollow support roller 101. As described earlier, the gas feed pipes 5 are metal pipes having many holes perforated therein or are porous pipes, and work to feed the reaction gases necessary for plasma CVD.

In the above-mentioned opposite-deposit apparatus, the interior of the vapor deposition chamber 35 is reduced to a predetermined degree of vacuum, predetermined reaction gases are fed through the gas feed pipes 5, surface-wave of microwave is fed from the surface-wave generator, and a vapor deposited layer is continuously formed on the surface 13b of the film 13 (on the surface of the side that is not facing the hollow support roller 101) as the film 13 is taken up by the take-up roller 53 from the starting material roller 51 via the hollow support roller 20. That is, the films are vapor-deposited successively on the surface 13b of the film 13 according to the above-mentioned principle as the film 13 passes over the dielectric electrode plates 10d of the surface-wave generator 10 for generating surface-waves in the vapor deposition chamber 35.

In the above opposite-deposit apparatus, it is desired to arrange deaerating pipes (not shown) so as to face the dielectric electrode plates 10d of the surface-wave generator 10. That is, upon evacuating, through the deaerating pipes, the reaction gases fed from the gas feed pipes 5, 5, the reaction gases of a predetermined concentration stay in the region (region near the surface 13b of the film 13) facing the dielectric electrode plates 10d, and a film of a predetermined composition can be deposited.

In the opposite-deposit apparatus of Fig. 4, too, the regions (plasma regions) facing the dielectric electrode plates 10d of the surface-wave generator 10 are sectioned to a degree that permits the passage of the film 13, and the reaction gases of varying compositions are fed to the regions to form a vapor deposited layer of a laminated layer structure on the surface 13b of the film 13. In the apparatus of fig. 4, for example, three plasma-treating zones are formed depending upon the number of the surface-wave generators 10 mounted on the hollow support roller 101 making it possible to form a vapor deposited layer of a three-layer structure (in the facing-deposit apparatus of Fig. 3 as described above, the plasma-treating zones A to D were formed, and the vapor deposited layer of a four-layer structure could be formed).

In the opposite-deposit apparatus of Fig. 4, too, it is desired to provide the film surface-treating device 60 at a position between the starting material roller 51 and the hollow support roller 101. That is, in a stage before the vapor deposited layer is formed by surface-wave of microwave fed from the surface-wave generators 10, the surface 13b to be treated of the long film 13 is treated by the film surface-treating device 60 in order to improve the adhesive property between the vapor deposited layer that is formed and the surface 13b of the long film 13.

The film surface-treating device, usually, executes a corona treatment or a plasma treatment by using argon, oxygen or the like.

In the facing-deposit apparatus of Fig. 3 or in the opposite-deposit apparatus of Fig. 4 described above, any known resin film can be used as the long film 13 on which the vapor deposited layer is to be formed. Namely, there can be used polyolefins of random or block copolymers of α-olefins, such as low-density polyethylene, high-density polyethylene, polypropylene, poly 1-butene, poly 4-methyl-1-pentene or ethylene, propylene, 1-butylene, and 4-methyl-1-pentene; various cyclic olefin copolymers; ethylene/vinyl compound copolymers such as ethylene/vinyl acetate copolymer, ethylene/vinyl alcohol copolymer, and ethylene/vinyl chloride copolymer; styrene resins such as polystyrene, acrylonitrile/styrene copolymer, ABS, and α-methylstyrene/styrene copolymer; vinyl resins such as polyvinyl chloride, polyvinylidene chloride, vinyl chloride/vinylidene chloride copolymer, methyl polyacrylate and methyl polymethacrylate; polyamides such as nylon 6, nylon 6-6, nylon 6-10, nylon 11 and nylon 12; thermoplastic polyesters such as polyethylene terephthalate, polybutylene terephthalate and polyethylene naphthalate; polycarbonates; polyphenylene oxide; biodegradable resin such as polylactic acid; or resins of mixtures thereof. Or, the long film may comprise a thermosetting resin such as polyimide or epoxy resin.

Further, the long film 13 may have a gas-barrier multi-layer structure using an olefin resin as an inner layer and an outer layer, and including an oxygen-absorbing layer between the inner layer and the outer layer. Upon forming the vapor deposited layer on the surface 13a or 13b of the long film having the above multi-layer structure, the oxygen-barrier property can be markedly improved.

The reaction gas used in the above apparatus for vapor deposition includes an organometal compound. Usually, therefore, a gas of the organometal compound and an oxidizing gas are used as reaction gases. As required, further, hydrocarbons that serve as a carbon source can be used together therewith.

As the organometal compound, an organosilicon compound can be preferably used. Not being limited to the organosilicon compound, however, there can be used an organoaluminum compound such as trialkylaluminum as well as an organotitanium compound and the like provided they form metal oxides upon reacting with an oxidizing gas. As the organosilicon compound, there can be used organosilane compounds such as hexamethyldisilane, vinyltrimethylsilane, methylsilane, dimethylsilane, trimethylsilane, diethylsilane, propylsilane, phenylsilane, methyltriethoxysilane, vinyltriethoxysilane, vinyltrimethoxysilane, tetramethoxysilane, tetraethoxysilane, phenyltrimethoxysilane, methyltrimethoxysilane or methyltriethoxysilane; and organosiloxane compounds such as octamethylcyclotetrasiloxane, 1,1,3,3-tetramethyldisiloxane and hexamethyldisiloxane. In addition to these materials, there can be used aminosilane and silazane. These organometal compounds may be used in a single kind or in a combination of two or more kinds. Further, silane (SiH₄) or silicon tetrachloride may be used together with the above organosilicon compound.

Oxygen and NOx are used as oxidizing gases, and argon and helium are used as carrier gases.

As the carbon source, further, hydrocarbons may be used, such as CH₄, C₂H₄, C₂H₆ and C₃H₈ in addition to the organosilicon compound and the organometal compound.

In the facing-deposit apparatus and in the opposite-deposit apparatus as described above, different plasma reaction conditions can be employed in the plasma regions (e.g., plasma regions A to D are formed in the facing-deposit apparatus of Fig. 3, and three plasma regions are formed in the opposite-deposit apparatus of Fig. 4) on the surfaces facing the surface-wave generator 10. Therefore, a vapor deposited layer comprising a laminate of layers of different properties can be continuously formed on the long film, which is a great advantage of the present invention.

That is, different organometal compounds are used in the plasma regions to form a vapor deposited layer which is a laminate of layers chiefly comprising different kinds of metal oxides.

Generally, further, it has been known that the vapor deposited layer having a high organic degree exhibits high adhesive property to the plastics as well as high water-repelling property while the vapor deposited layer containing much metal oxide components (highly inorganic) exhibits low adhesive property to the plastics but high gas-barrier property. By utilizing this, therefore, a highly organic layer is formed on the surface side of the long film 13, a highly inorganic layer is formed as an intermediate layer, and, again, a highly organic layer is formed on the outer surface; i.e., a vapor deposited layer is formed having excellent adhesive property to the long film 13, excellent gas-barrier property and favorable water-repelling property. The film forming the above vapor deposited layer is best suited for use as packages for containing various beverages.

Referring, for example, to the facing-deposit apparatus shown in Fig. 3, the compositions of reaction gases are adjusted in the plasma regions A to D to easily form the vapor deposited layer having a layer structure as described above. That is, when the oxidizing gas is fed in a small amount as compared to the organometal compound, the organometal compound is oxidized and decomposed to a low degree. Namely, a polymer is formed and, as a result, the vapor deposited layer that is formed contains carbon in large amounts and becomes rich in organic property, exhibiting high adhesive property to the plastics and high water-repelling property. By feeding the oxidizing gas in large amounts as compared to the organometal compound, further, the organometal compound is oxidized and decomposed to a high degree, and a nearly complete metal oxide is formed. As a result, the vapor deposited layer that is formed contains carbon in small amounts and becomes rich in inorganic property, exhibiting high gas-barrier property. In the above plasma regions A and D, therefore, the gas of the organometal compound only is fed, or the oxidizing gas such as of oxygen is fed in decreased amounts while feeding the gas of the organometal compound, to thereby form a layer having high adhesive property on the surface side of the long film 13 which is the base material and to, further, form a layer having high water-repelling property on the outer surface. In the plasma regions B and C, on the other hand, the oxidizing gas is fed in increased amounts as compared to the organometal compound so as to form, as the intermediate layer, a layer having a small C content and is rich in inorganic property exhibiting high gas-barrier property.

The above laminated-layer structure can be further formed by adjusting the output of microwaves in addition to adjusting the composition of the reaction gases. That is, if the microwave output is decreased, a layer is formed containing carbon in large amounts, exhibiting high adhesive property to the plastics and exhibiting excellent water-repelling property. If the microwave output is increased, a layer is formed containing carbon in small amounts, becoming rich in inorganic property and exhibiting high gas-barrier property.

The method of varying the output is based on a principle that is described below.

If described referring, for example, to an organosilicon oxide, it is considered that a silicon oxide film is formed by the organosilicon compound and by the oxidizing gas through the following reaction path:
(a) Abstraction of hydrogen: SiCH₃ → SiCH₂
(b) Oxidation: SiCH₂ → SiOH
(c) Dehydration and condensation: SiOH → SiO

That is, if a glow discharge is executed maintaining a large output, e.g., using microwaves of an output of not smaller than 100 W, the organosilicon compound reacts up to the step (c) at one time. As a result, the oxidation and decomposition are effected to a high degree, and a layer is formed containing carbon in small amounts and having high gas-barrier property. On the other hand, if the glow discharge is executed maintaining a small output, e.g., using microwaves of about 20 to about 80 W, radicals SiCH₂ formed at the step (a) undergo the reaction forming a polymer of an organosilicon compound. As a result, a layer is formed containing carbon in large amounts, i.e., having high adhesive property to the plastics and exhibiting favorable water-repelling property. It is, therefore, desired to form a layer having high gas-barrier property by producing microwaves or a low output in the plasma regions A and D, and producing microwaves of a high output in the plasma regions B and C.

The composition of the reaction gases and the output of microwaves are suitably adjusted depending upon the number of the plasma regions provided in the apparatus and the required properties of the vapor deposited layer. When, for example, water-repelling property is not required, the reaction condition can be so set that the layer rich in inorganic property and having high gas-barrier property is on the most outer surface of the vapor deposited layer.

In the above facing-deposit apparatus, a deaerating hole 59a may be formed in the partitioning wall 59 for each of the plasma regions A to D, the position of the deaerating hole 59a in each partitioning wall 59 being so set that the flow of gas will not hinder the occurrence of plasma.

If the reaction gas has the same composition and the plasma reaction conditions are varied relying only upon the output of microwaves in the plasma regions A to D, then the partitioning walls 59 may be omitted among the plasma regions (e.g., between the plasma regions A and B, between B and C, and between C and D).

In the foregoing was described the case of the facing-deposit apparatus of Fig. 3. In the opposite-deposit apparatus of Fig. 4, too, the vapor deposited layer of a desired layer structure can be obtained by similarly adjusting the compositions of the reaction gases and the output of the microwaves.

## Claims

1. A method of forming a vapor deposited layer comprising following steps of:
arranging a surface-wave generator for generating surface-wave by microwave in a vacuum region;
continuously feeding a plastic base film into said vacuum region so as to face said surface-wave generator;
continuously feeding a reaction gas containing at least an organometal compound into said vacuum region; and
executing a plasma reaction by surface-wave of microwave from said surface-wave generator to thereby continuously form a vapor deposited layer on a surface of the base film.

2. The method of forming a vapor deposited layer according to claim 1, wherein a plurality of the surface-wave generators are arranged side by side along a direction in which said base film moves, gaps among the adjacent surface-wave generators are partitioned to a degree that permits said base film to move, and the vapor deposited layer is continuously formed on the surface of said base film by the plasma reaction due to the surface-wave generators while continuously moving said base film.

3. The method of forming a vapor deposited layer according to claim 2, wherein by varying, for each of the surface-wave generators, the kind or composition of the reaction gas or the output of microwave, the plasma reaction is executed in every surface-wave generators to form the vapor deposited layer having a multi-layer constitution.

4. The method of forming a vapor deposited layer according to claim 1, wherein a long film is used as said base film.

5. The method of forming a vapor deposited layer according to claim 4, wherein a starting material roller on which said long film is wound and a take-up roller for taking up said long film are arranged in said vacuum region, and the vapor deposited layer is continuously formed on the surface of said long film while the long film wound on said starting material roller is being taken up by the take-up roller.

6. The method of forming a vapor deposited layer according to claim 1, wherein said base film is fed maintaining a gap to said surface-wave generator, and said reaction gas is fed so as to flow into spaces between said base film and the surface-wave generator, to thereby form the vapor deposited layer on the surface of said base film on the side facing the surface-wave generator.

7. The method of forming a vapor deposited layer according to claim 1, wherein a surface for emitting surface-wave of said surface-wave generator is formed as a curved surface, and said base film is fed along said curved surface in a manner that the one surface thereof comes in close contact with said curved surface, to thereby form the vapor deposited layer on the other surface of said base film.

8. An apparatus for forming a vapor deposited layer comprising a base material conveyer chamber and a vapor deposition chamber formed so as to be communicated with each other in a housing maintained in a vacuum state, wherein:
a starting material roller and a take-up roller are arranged in said base material conveyer chamber;
a support roller is arranged in said vapor deposition chamber, and a plurality of plasma regions sectioned by partitioning members are formed surrounding said support roller along a surface of said support roller;
in each of said plasma regions, there are provided a surface-wave generator for generating surface-wave by microwave supported by a housing wall that is forming said vapor deposition chamber, and a gas feed pipe inserted in a space between said surface-wave generator and the surface of the support roller; and
by executing a plasma reaction in each of the plasma regions due to feeding surface-wave of microwave from the surface-wave generator and feeding a reaction gas from the gas feed pipe while taking up, on said take-up roller, a long film wound on said starting material roller, a vapor deposited layer is continuously formed on a surface of the long film on the side facing the surface-wave generator.

9. The apparatus for forming a vapor deposited layer according to claim 8, wherein said partitioning members are deaerating members.

10. The apparatus for forming a vapor deposited layer according to claim 8, wherein a housing wall forming said vapor deposition chamber is formed in a circular shape in concentric with the surface of said support roller.

11. The apparatus for forming a vapor deposited layer according to claim 8, wherein a film surface-treating device is arranged in said base material conveyer chamber, and after a surface of the long film is treated by said film surface-treating device, the long film is fed onto the support roller so that the vapor deposited layer is formed thereon.

12. A microwave feeding device for plasma CVD comprising a hollow support member of which an outer surface is at least curved, and a surface-wave generator for generating surface-wave by microwave supported by said hollow support member, wherein:
said surface-wave generator is constituted by a waveguide connecting to a microwave feed source and extending in said hollow support member, a slot antenna incorporated in a shielding wall of said waveguide and a dielectric electrode plate which is so provided as to cover said slot antenna, said dielectric electrode plate being incorporated and fixed in the wall of said hollow support member in a manner that the outer surface thereof is exposed; and
an outer surface of said dielectric electrode plate is curved so as to be smoothly continuous to the outer surface of said hollow support member.

13. The microwave feeding device for plasma CVD according to claim 12, wherein said hollow support member has the shape of a roller, and the outer surface of said dielectric electrode plate is formed in a circular shape substantially in concentric with the outer surface of said roller-shaped hollow support member.

14. The microwave feeding device for plasma CVD according to claim 12, wherein a plurality of the surface-wave generators are supported on the curved surface of said hollow support member along the circumferential direction thereof.

15. An apparatus for forming a vapor deposited layer comprising a starting material roller on which a long plastic film is wound, a take-up roller for taking up said film, and a microwave feeding device for plasma CVD of claim 12 in a housing maintained in a vacuum state, wherein:
a gas feed pipe is extending facing an outer surface of the dielectric electrode plate of the microwave feeding device maintaining a small gap; and
by executing a plasma reaction due to feeding surface-wave of microwave and feeding a reaction gas from the gas feed pipe while taking up, on said take-up roller, the long plastic film wound on said starting material roller along the curved surface of the hollow support member of the microwave feeding device and passing through between the hollow support member and the gas feed pipe, a vapor deposited layer is continuously formed on the surface of the long plastic film on the side that does not face an outer surface of the dielectric electrode plate.

16. The apparatus for forming a vapor deposited layer according to claim 15, wherein a film surface-treating device is arranged in said housing, and after the surface of the long plastic film is treated by said film surface-treating device, said long plastic film is fed passing through between said hollow support member and the gas feed pipe so that the vapor deposited layer is formed thereon.
